# EUROPÄISCHE PATENTANMELDUNG

(11) **EP 1 209 741 A2**
(43) Veröffentlichungstag der Anmeldung: **29.05.2002**
(21) Anmeldenummer: 01127633.4
(22) Anmeldetag: 20.11.2001
(51) Int. Cl.: H01L 23/433, H01L 23/552

(54) **Vorrichtung für einen getakteten Halbleiterchip**

(30) Priorität: 22.11.2000 DE 10057973
(71) Anmelder: SIEMENS AKTIENGESELLSCHAFT, 80333 München (DE)
(72) Erfinder: Grünebaum, Hubert, 78078 Niedereschach (DE); Wolf, Jürgen, 78048 Villingen-Schwenningen (DE)

(57) **Zusammenfassung**

Für eine Vorrichtung für einen getakteten Halbleiterchip, wobei der Halbleiterchip (1) auf einem mit elektrischen Leiterbahnen versehenen Träger (2) montiert ist, wird vorgeschlagen, einen aus einem wärmeleitenden Werkstoff bestehenden, den Halbleiterchip (1) zumindest teilweise überdeckenden Schirmkörper (3) zwischen der Oberfläche des Halbleiterchips (1) und einem zum Halbleiterchip (1) gehörenden Kühlelement (4) anzuordnen,
- wobei der Schirmkörper (3) sowohl zum Halbleiterchip (1) als auch zum Kühlelement (4) in wärmeleitender Verbindung steht und
- wobei der Schirmkörper (3) Ferrit enthält, um elektromagnetische Störsignale zu absorbieren, die der Halbleiterchip (1) aufgrund seiner Taktfrequenz abstrahlt.

## Beschreibung

Die Erfindung betrifft eine Vorrichtung für einen getakteten Halbleiterchip, insbesondere für einen Mikroprozessor oder Mikrocontroller. Getaktete Halbleiterchips werden zur Erreichung immer höherer Arbeitsgeschwindigkeiten mit immer höheren Taktfrequenzen angesteuert. Derartige Taktfrequenzen liegen heute bereits im Bereich von mehreren hundert Megahertz und damit im Hochfrequenzbereich, der von vielfältigen elektronischen Kommunikationseinrichtungen zur drahtlosen Nachrichtenübertragung genutzt wird. Der Betrieb eines mit einer hohen Taktfrequenz getakteten Halbleiterchips geht also mit zwei Problemen einher, nämlich daß sich der Halbleiterchip durch seine hohe Taktung stark erwärmt und daß er für andere elektronische Einrichtungen elektromagnetische Störsignale erzeugt, nämlich insbesondere durch Abstrahlung hochfrequenter Oberwellen.

Gerade bei automotiven Anwendungen derartiger Halbleiterchips führen die von ihnen abgestrahlten Störsignale zu einer bisweilen gefährlichen Beeinflussung anderer Steuereinrichtungen oder zumindest zu einer qualitativen Beeinträchtigung von in einem Fahrzeug angeordneten Kommunikationseinrichtungen wie Radio, Funk oder Telefon. Die Beeinflussung bzw. Beeinträchtigung kann im schlimmsten Fall zu einem totalen Funktionsausfall der genannten Steuereinrichtungen bzw. Kommunikationseinrichtungen führen, weshalb in einem Fahrzeug ein von einem Halbleiterchip resultierender hoher Störpegel nicht tolerierbar ist. Es ist zwar bekannt, Steuereinrichtungen bzw. Kommunikationseinrichtungen mit geeigneten Schutzbeschaltungen wie Filtern etc. auszustatten, um eine negative Einflußnahme durch aus ihrer Umgebung eingestrahlte Signale auf ein Minimum zu reduzieren, jedoch ist es sinnvoller, elektromagnetische Störsignale an ihrer Quelle zu beseitigen oder dort zumindest ihre Wirkung in erheblichem Maße abzuschwächen bzw. zu begrenzen.

Zur Wärmeabfuhr ist deshalb in der Regel eine Zwangskühlung vorgesehen, die derart ausgestaltet sein kann,
- daß am Halbleiterchip zur Vergrößerung von dessen Wärme abstrahlender Fläche ein Kühlkörper angebracht ist,
- daß ein Lüfter oder ein Luftkanal vorgesehen ist, der zum Abtransport der vom Halbleiterchip abgegebenen Wärme einen über den Halbleiterchip strömenden Luftstrom erzeugt bzw. bereitstellt, oder
- daß der Halbleiterchip mit einer Folge von elektrischen Leitern in Wirkverbindung gebracht ist, um durch Nutzung des Peltier-Effekts eine Wärmepumpe zu realisieren.

Diese Maßnahmen können allein oder in Kombination zum Einsatz gebracht werden. Beachtlich ist hierbei,
- daß aktive Zwangskühlungen durch einen erzeugten Luftstrom oder durch ein Peltierelement ihrerseits eine elektronische Steuerung erfordern und damit in ihrer Realisierung relativ aufwendig sind,
- daß sie zwangsläufig den Energieverbrauch der Baueinheit erhöhen, in der sie angeordnet sind, was aber gerade in einem Fahrzeug unerwünscht ist,
- daß sie unter Umständen sogar selbst überwacht werden müssen und
- daß sie im Gesamtsystem "Fahrzeug" eine zusätzliche Fehlerquelle darstellen, weil auch bei ihnen eine Betriebsstörung nicht grundsätzlich ausgeschlossen werden kann.

Zur Abschirmung elektromagnetischer Störsignale werden zumeist hohe Frequenzen absorbierende Bleche aus einem Eisen- oder Aluminiumwerkstoff eingesetzt oder im Innenbereich des den Halbleiterchip umgebenden Gehäuses sind aus einem entsprechenden Werkstoff bestehende Beschichtungen aufgetragen, wobei diese Ausbildungen einer Abschirmung in einigem Abstand zum Halbleiterchip angeordnet werden müssen, um eine Reduktion ihrer schirmenden Wirkung zu vermeiden. Dadurch erfordern derartige Anordnungen jedoch ein relativ großes Bauvolumen, welches insbesondere in Fahrzeugen nur schwerlich zur Verfügung gestellt werden kann.

Es ist nun die Aufgabe der vorliegenden Erfindung, eine Vorrichtung für einen getakteten Halbleiterchip aufzuzeigen, die bei geringem Platzbedarf wärmeabführend wirkt und gleichzeitig hochfrequente elektromagnetische Strahlung absorbiert.

Die Aufgabe wird durch eine Vorrichtung für einen getakteten Halbleiterchip mit den Merkmalen des ersten Anspruchs gelöst. Die Lösung sieht insbesondere vor,
- daß ein aus einem wärmeleitenden Werkstoff bestehender, den Halbleiterchip zumindest teilweise überdeckender Schirmkörper zwischen der Oberfläche des Halbleiterchips und einem zum Halbleiterchip gehörenden Kühlelement angeordnet ist,
- daß der Schirmkörper sowohl zum Halbleiterchip als auch zum Kühlelement in wärmeleitender Verbindung steht und
- daß der Schirmkörper Ferrit enthält, um elektromagnetische Störsignale zu absorbieren, die der Halbleiterchip aufgrund seiner Taktfrequenz abstrahlt.

Weitere vorteilhafte Ausgestaltungen und Weiterbildungen der gefundenen Lösung ergeben sich auch in Verbindung mit der anliegenden **Figur**, mit deren Hilfe die Lösung nun noch verdeutlicht werden soll.

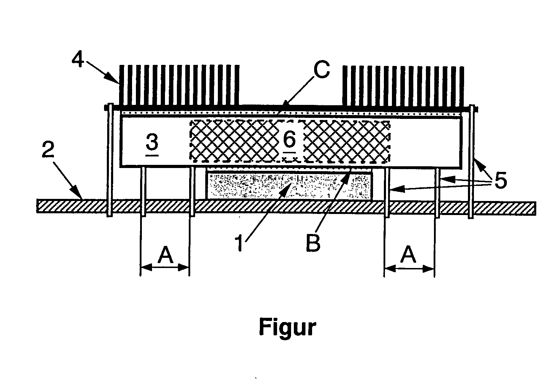

Ein getakteter Halbleiterchip 1 ist auf einem mit elektrischen Leiterbahnen versehenen Träger 2 montiert, wobei der Träger 2 in der Regel als eine Leiterplatte ausgestaltet ist. Ein vorzugsweise flach ausgebildeter Schirmkörper 3 überdeckt den auf dem Träger 2 montierten Halbleiterchip 1 zumindest teilweise, nämlich zumindest in diejenige Raumrichtungen, in denen eine schirmende Wirkung vor elektromagnetischen Störsignalen beabsichtigt ist. Dabei kann der Schirmkörper 3 beispielsweise eine Schichtdicke von 2 Millimeter haben. Der Schirmkörper 3 besteht aus einem wärmeleitenden Werkstoff und steht sowohl zum Halbleiterchip 1 als auch zu einem Kühlelement 4 in wärmeleitender Verbindung, d. h. an den in der Figur aus zeichentechnischen Gründen beabstandet dargestellten jeweiligen Berührungsstellen B und C von Halbleiterchip 1, Schirmkörper 3 und Kühlelement 4 soll ein möglichst ungehinderter Wärmeübergang gegeben sein. Diese wärmeleitende Verbindung kann durch eine formschlüssige Gestaltung der Auflageflächen von Halbleiterchip 1, Schirmkörper 3 und Kühlelement 4 in Verbindung mit einer Klemmung des Schirmkörpers 3 zwischen dem Halbleiterchip 1 und dem Kühlelement 4 realisiert sein. Um den Wärmeübergang vom Halbleiterchip 1 zum Schirmkörper 3 und vom Schirmkörper 3 zum Kühlelement 4 noch weiter zu verbessern, sind diese Wärmeübergangsstellen B und C vorzugsweise mit einer Wärmeleitpaste, einem Wärmeleitkleber oder einer Wärmeleitfolie versehen. Das Kühlelement 4 kann in gewohnter Weise als ein Kühlkörper in Rippenform oder als ein wabenförmiges Lochblech ausgestaltet sein. Wenn der Kühlkörper aus Aluminium besteht, empfiehlt sich seine Eloxierung. Der Schirmkörper 3 und auch das Kühlelement 4 können durch Zapfen 5 an dem Träger 2 befestigt sein, wobei die Zapfen 5 vorzugsweise in regelmäßigen Abständen gesetzt sind und wobei ein geeigneter Abstand A für die Zapfen 5 unter Berücksichtigung der zu dämpfenden Frequenz ermittelt wird. Bei einer abzuschirmenden Frequenz von z. B. f = 400 MHz empfiehlt sich ein Abstand A von ca. 30 Millimeter. Die Zapfen 5 sind an dem Träger 2 vorzugsweise durchkontaktiert und dort geerdet. Als Werkstoff für den Schirmkörper 3 ist Ferrit wegen seiner Strahlung absorbierenden Wirkung vorteilhaft. Der Schirmkörper 3 kann entweder vollständig aus Ferrit gefertigt sein oder einen flachen, den Halbleiterchip 1 überdeckenden Kern 6 aus Ferrit besitzen. Sofern es nicht notwendig ist, daß der Schirmkörper 3 bzw. dessen aus Ferrit bestehender Kern 6 den Halbleiterchip 1 vollständig überdeckt, sind für den Schirmkörper 3 natürlich auch andere dem Abstrahlverhalten des Halbleiterchips 1 angepaßte Geometrien möglich, die je nach Bedarf von partiellen Überdeckungen bis hin zu mantelförmigen Einfassungen des Halbleiterchips 1 reichen können. Ebenso lassen sich auch zur Erhöhung der Absorption elektromagnetischer Störsignale pulverförmige Ferritwerkstoffe in eine Paste als Substitut für eine eingesetzte Wärmeleitpaste, einen Wärmeleitkleber oder eine Wärmeleitfolie einbringen oder aber die Wärmeleitpaste, der Wärmeleitkleber oder die Wärmeleitfolie sind derart beschaffen, daß sie selbst pulverförmige Ferritwerkstoffe enthalten. Auch können in einer weiteren Ausgestaltung der Erfindung der Schirmkörper 3 und das Kühlelement 4 zu einem einstückigen Bauelement verpreßt sein oder es sind direkt am Schirmkörper 3 einen Kühlkörper bildende, Wärme abstrahlende Flächen oder Rippen angeformt.

Durch die vorgeschlagene Anordnung von Schirmkörper 3 und Kühlelement 4 wird erreicht, daß eine Vorrichtung für einen getakteten Halbleiterchip 1 entsteht, die bei geringem Platzbedarf wärmeabführend wirkt und gleichzeitig hochfrequente elektromagnetische Strahlung absorbiert. Auf diese Weise lassen sich äußerst flache Bauformen realisieren, die sich auch für Mikrocontroller zur Ansteuerung von Kombiinstrumenten in Fahrzeugen eignen.

## Patentansprüche

1. Vorrichtung für einen getakteten Halbleiterchip,
1.1. wobei der Halbleiterchip (1) auf einem mit elektrischen Leiterbahnen versehenen Träger (2) montiert ist,
**dadurch gekennzeichnet,**
1.2. daß ein aus einem wärmeleitenden Werkstoff bestehender, den Halbleiterchip (1) zumindest teilweise überdeckender Schirmkörper (3) zwischen der Oberfläche des Halbleiterchips (1) und einem zum Halbleiterchip (1) gehörenden Kühlelement (4) angeordnet ist,
1.3. daß der Schirmkörper (3) sowohl zum Halbleiterchip (1) als auch zum Kühlelement (4) in wärmeleitender Verbindung steht und
1.4. daß der Schirmkörper (3) Ferrit enthält, um elektromagnetische Störsignale zu absorbieren, die der Halbleiterchip (1) aufgrund seiner Taktfrequenz abstrahlt.

2. Vorrichtung für einen getakteten Halbleiterchip nach Anspruch 1,
**dadurch gekennzeichnet,**
**daß** der Schirmkörper (3) flach ausgebildet ist.

3. Vorrichtung für einen getakteten Halbleiterchip nach einem der vorangegangenen Ansprüche,
**dadurch gekennzeichnet,**
**daß** der Schirmkörper (3) vollständig aus Ferrit gefertigt ist oder einen den Halbleiterchip (1) zumindest teilweise überdeckenden Kern (6) aus Ferrit besitzt.

4. Vorrichtung für einen getakteten Halbleiterchip nach einem der vorangegangenen Ansprüche,
**dadurch gekennzeichnet,**
**daß** der Schirmkörper (3) zwischen der Oberfläche des Halbleiterchips (1) und dem zum Halbleiterchip (1) gehörenden Kühlelement (4) verklemmt ist.

5. Vorrichtung für einen getakteten Halbleiterchip nach einem der vorangegangenen Ansprüche,
**dadurch gekennzeichnet,**
**daß** die Wärmeübergangsstellen zwischen dem Halbleiterchip (1) und dem Schirmkörper (3) bzw. zwischen dem Schirmkörper (3) und dem zum Halbleiterchip (1) gehörenden Kühlelement (4) mit einer Wärmeleitpaste, einem Wärmeleitkleber oder einer Wärmeleitfolie versehen sind.

6. Vorrichtung für einen getakteten Halbleiterchip nach Anspruch 5,
**dadurch gekennzeichnet,**
**daß** die Wärmeleitpaste, der Wärmeleitkleber oder die Wärmeleitfolie pulverförmige Ferritwerkstoffe enthalten.

7. Vorrichtung für einen getakteten Halbleiterchip nach einem der vorangegangenen Ansprüche,
**dadurch gekennzeichnet,**
**daß** das Kühlelement (4) als ein Kühlkörper in Rippenform oder als ein wabenförmiges Lochblech ausgestaltet ist.

8. Vorrichtung für einen getakteten Halbleiterchip nach einem der vorangegangenen Ansprüche,
**dadurch gekennzeichnet,**
**daß** der Schirmkörper (3) oder das Kühlelement (4) durch Zapfen (5) an dem Träger (2) befestigt sind, wobei die Zapfen (5) in regelmäßigen Abständen gesetzt sind und ein geeigneter Abstand der Zapfen (5) unter Berücksichtigung der zu dämpfenden Frequenz ermitteln wird.

9. Vorrichtung für einen getakteten Halbleiterchip nach Anspruch 8,
**dadurch gekennzeichnet,**
**daß** die Zapfen (5) am Träger (2) geerdet sind.

10. Vorrichtung für einen getakteten Halbleiterchip nach einem der vorangegangenen Ansprüche,
**dadurch gekennzeichnet,**
**daß** der Schirmkörper (3) und das Kühlelement (4) zu einem einstückigen Bauelement verpreßt sind.

11. Vorrichtung für einen getakteten Halbleiterchip nach einem der vorangegangenen Ansprüche,
**dadurch gekennzeichnet,**
**daß** am Schirmkörper (3) Wärme abstrahlende Flächen oder Rippen angeformt sind.
